# EUROPEAN PATENT APPLICATION

(11) **EP 1 081 255 A2**
(43) Date of publication of application: **07.03.2001**
(21) Application number: 00301656.5
(22) Date of filing: 01.03.2000
(51) Int. Cl.: C30B 25/02, C30B 29/06, C30B 29/08, C30B 29/68

(54) **A three-dimensional periodic structure and a method for producing the same**

(30) Priority: 01.09.1999 JP 24718199
(71) Applicant: Tohoku University, Sendai City, Miyagi Prefecture (JP)
(72) Inventor: Matsuura, Takashi, Sendai City, Miyagi Pref. (JP); Murota, Junichi, Sendai City, Miyagi Pref. (JP)
(74) Representative: Mohun, Stephen John

(57) **Abstract**

A three-dimensional periodic structure having pattern layers and thin layers, in which the pattern layers are stacked, the adjacent pattern layers being composed of plural different kinds of material, respectively, each pattern layer having the arrangement of the plural different kinds of material periodically repeated at every kind of material in both directions of the two-dimensional direction orthogonal to the stacking direction, and each thin layer is intervened each between the adjacent pattern layers.

## Description

This invention relates a three-dimensional periodic structure made by artificial structure-controlling and a method for producing the same.

A three-dimensional periodic structure having an arrangement of each of plural kinds of material repeated in each of three dimensional directions is produced by the following method, for example.

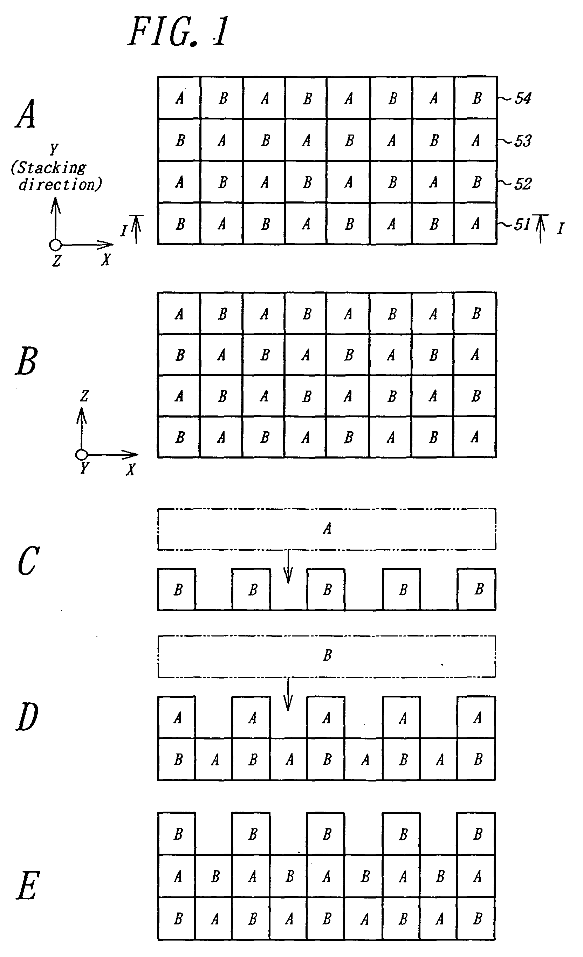

For example, in producing a three-dimensional periodic structure made of two kinds of material "A" and "B" shown in Figs. 1A and 1B, first of all, a pattern layer 51 is formed in a bottom position of Fig. 1A. The pattern layer 51 has an arrangement of the two kinds of material "A" and "B" alternately repeated in a X-direction and a Y-direction orthogonal to their stacking direction (Y-direction) as shown in Fig. 1B which is a cross sectional view, taken on line "I-I" of Fig. 1A. In forming such a pattern layer 51, 52. 53 or 54, for example, the material "A" is deposited on a pattern of the material "B" shown in Fig. 1C to form a pattern shown in Fig. 1D, and thereafter, the material "B" is deposited on the pattern of Fig. 1D again to form a pattern shown in Fig. 1E similar to the pattern of Fig. 1C.

Such successive steps are repeated and the pattern layers 51, 52. 53, 54 · · · are stacked in turn so that they can have the arrangement of the materials "A" and "B" shifted in the X-direction by one low between the adjacent pattern layers, which results in a periodically repeated arrangement of the materials "A" and "B" in the stacking direction, so that the three-dimensional periodic structure shown in Figs. 1A and 1B can be obtained.

In producing such a three-dimensional periodic structure in a minute dimension of micro meter-order or below, such a known technique as (1) a sputter alternate depositing method on a given pattern (S. Kawasaki, Electronics Letters, Vol.33, p1260 (1997) or (2) a stick bonding method for wafers with patterns (S. Noda, N. Yamamoto, and A. Sasaki, Japanese Journal of Applied Physics. Vol. 35, p1909 (1996)) have been used.

However, the production of a three-dimensional periodic structure by the above conventional method brings about many problems in the producing process as follows: For example, since in the above conventional method (1), it is difficult to control deposition conditions in repeated deposition, it is difficult to produce an ideal three-dimensional periodic structure having pattern layers matched in their shapes. Moreover, the above conventional method (2), the stick bonding method has difficulty in controlling its bonding condition and takes much time.

As mentioned above, a method for producing a three-dimensional periodic structure to be easily produced highly consistent with a semiconductor integrated circuit is not suggested up to now.

Embodiments of the present invention aim to provide a three-dimensional periodic structure having stacked pattern layers with dimensions of micro meter-order or below and a producing method of the same.

The present invention is defined in the attached independent claims, to which reference should now be made. Preferred features may be found in the sub-claims appended thereto.

In one aspect the invention provides a three-dimensional periodic structure comprising pattern layers and thin or intervening, unpatterned layers, the pattern layers being stacked, the adjacent pattern layers being composed of plural different kinds of material, respectively, each pattern layer having the arrangement of the plural different kinds of material periodically repeated at every kind of material in both directions of the two-dimensional direction orthogonal to the stacking direction, each thin layer being intervened each between the adjacent pattern layers.

The invention also provides a three-dimensional periodic structure comprising pattern layers and thin layers, the pattern layers being stacked, the adjacent pattern layers being composed of plural different kinds of material, respectively, each pattern layer having the arrangement of the plural different kinds of material periodically repeated at every kind of material in one direction of the two-dimensional direction orthogonal to the stacking direction, each thin layer being intervened each between the adjacent pattern layers.

At least one of the plural different kinds of material may be selectively grown and the thin layer may be of a material usable for a seed of the selective growth.

At least one of the plural different kinds of material and the material constituting the thin layer may be Si, Ge, SiGe mixed crystal, W, Si-oxide or a combination of these materials.

Preferably the thickness of each pattern layer is micro meter-order or below.

In a preferred arrangement the thickness of the thin layer is one-third or below of that of each pattern layer.

The invention also provides a method for producing a three-dimensional periodic structure comprising the steps of:
preparing a substrate,
forming a pattern layer in which plural different kinds of material are periodically repeated at every kind of material in both directions of two-dimensional direction orthogonal to its stacking direction, and
stacking the pattern layer and a thin layer alternately and repeatedly.

The invention also provides a method for producing a three-dimensional periodic structure comprising the steps of:
preparing a substrate,
forming a pattern layer in which plural different kinds of material are periodically repeated at every kind of material in one direction of two-dimensional direction orthogonal to its stacking direction, and
stacking the pattern layer and a thin layer alternately and repeatedly,

At least one of the plural different kinds of material may be selectively grown and the thin layer may be made of a material usable for a seed of the selective growth.

At least one of the plural different kinds of material and the material constituting the thin layer may be Si, Ge, SiGe mixed crystal, W, Si-oxide or a combination of these materials.

Preferably the pattern layer and the thin layer are formed of Si, Ge, SiGe mixed crystal or W by a selective CVD method or a sputtering method, or of Si-oxide by a selective liquid phase growth method, an atmospheric pressure CVD method or a sputtering method.

The thickness of each pattern layer may be micro meter-order or below.

Preferably the thickness of the thin layer is one-third or below of that of pattern layer.

When in the three-dimensional periodic structure having plural pattern layers of which each has a pattern of plural kinds of material periodically arranged in both directions of a two-dimensional direction orthogonal to their stacking direction, a thin layer is intervened each between the adjacent pattern layers, each of the pattern layers can be formed by a selectively growing method. Consequently, the shape-controlling of the pattern layers can be very easily enhanced and a desired three-dimensional periodic structure can be obtained.

Since in the three-dimensional periodic structure has plural pattern layers of which each has a pattern of plural kinds of material periodically arranged in one direction of a two-dimensional direction orthogonal to their stacking direction, a thin layer is intervened each between the adjacent pattern layers, each of the pattern layers can be formed by a selectively growing method. Consequently, the shape-controlling of the pattern layers can be very easily enhanced and a desired three-dimensional periodic structure can be obtained.

If at least one of the plural kinds of material constituting the pattern layers is a material capable of being selectively grown and the thin layer is made of a material usable for a seed of selective growth, the successive stacked pattern layers can be formed by selective growth technique.

If the pattern layer and the thin layer are made of Si, Ge, SiGe mixed crystal, W, Si-oxide, a combination of these materials, the pattern can be selectively grown on the thin layer as a seed of selective growth.

When the pattern layer has a thickness of micro meter-order or below, the three-dimensional periodic structure in which the pattern layers are stacked in desired dimension of micro meter-order or below can be produced.

When the thickness of the thin layer is one-third or below of that of the pattern layer, the thin layer can be used as a seed of selective growth.

When the three-dimensional periodic structure has plural pattern layers of which each has a pattern of plural kinds of material periodically arranged in both directions of a two-dimensional direction orthogonal to their stacking direction, each of the pattern layers is stacked with a thin layer film being intervened each between the adjacent pattern layers, the successive stacked pattern layers can be formed by selective growth technique. Thus, the shape-controlling of the pattern layer can be easily enhanced and a desired three-dimensional periodic structure can be obtained.

When the three-dimensional periodic structure has plural pattern layers of which each has a pattern of plural kinds of material periodically arranged in one directions of a two-dimensional direction orthogonal to their stacking direction, each of the pattern layers is stacked with a thin layer film being intervened each between the adjacent pattern layers, the successive stacked pattern layers can be formed by selective growth technique. Thus, the shape-controlling of the pattern layer can be easily enhanced and a desired three-dimensional periodic structure can be obtained.

If some of the pattern layers are selectively grown from at least one of the plural materials, and the thin layer is used as a seed of the selective growth, the successive stacked pattern layers can be formed by selective growth technique.

If the pattern layer and the thin layer are made of Si, Ge, SiGe mixed crystal, W, Si-oxide, a combination of these materials, the pattern can be selectively grown on the thin layer as a seed of selective growth.

If the pattern layer and the thin layer are formed of Si, Ge, SiGe mixed crystal or W by a CVD selective growth method or a sputtering method, or of Si-oxide by a selective liquid phase growth method, an atmospheric pressure CVD method or a sputtering method, the successive stacked pattern layers can be formed by selective growth technique such as any one of the above methods.

If the pattern layer has a thickness of micro meter-order or below, a three-dimensional periodic structure having the stacked pattern layers with desired minute dimensions of micro meter-order or below can be obtained.

If the thickness of the thin layer is one-third or below of that of the pattern layer, the thin layer can be used as a seed of selective growth.

Embodiments of the present invention will now be described, by way of example, with reference to the accompanying drawings, in which:
Figs. 1A-1E are general views for explaining the producing method of a known three-dimensional periodic structure.
Figs. 2A-2E are general views for explaining a producing method of a first embodiment three-dimensional periodic structure according to the present invention,
Figs. 3A-3E are general views for explaining a producing method of a second embodiment three-dimensional periodic structure according to the present invention, and
Fig. 4 is a general view for explaining the structure of the third embodiment three-dimensional periodic structure according to the present invention.

For example, in producing the three-dimensional periodic structure having the pattern layers made of two kinds of material "A" and "B", which is simplest one, shown in Figs. 1A and 1B, as is explained about the known technique above, the steps of forming the pattern made of the material "B" shown in Fig. 1C, stacking the pattern made of the material "A" shown in Fig. 1D, and stacking the pattern made of the material "B" shown in Fig. 1E have to be repeated.

For realizing such a producing method, a first embodiment three-dimensional periodic structure is produced by the following steps. Hereupon, in the two kinds of material constituting the three-dimensional periodic structure, the material "A" is SiGe mixed crystal and the material "B" is SiO₂. Moreover, the thin layer intervened between the pattern layers made of the materials "A" and "B" is a thin layer having a whole surface to be selectively grown made of Si.

### [1-1] SiO₂ deposition

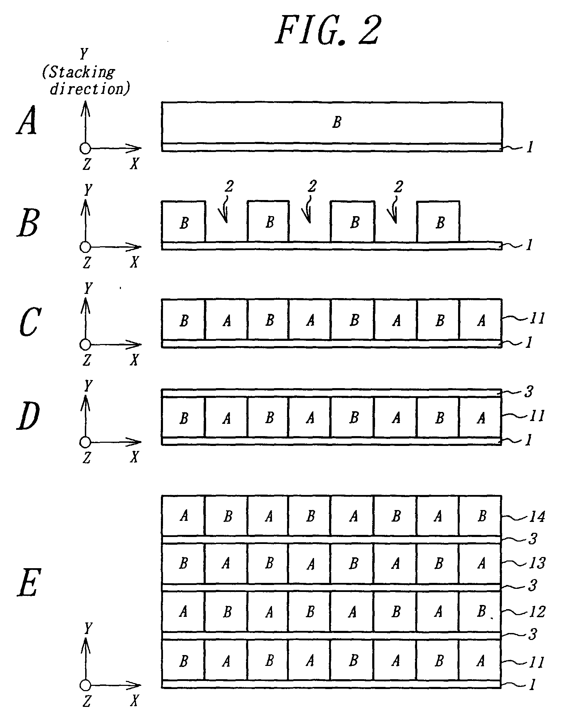

As shown in Fig. 2A, a SiO₂ layer is formed, of a SiH₄-O₂-N₂ based mix gas, in a thickness of 0.5 µm on a substrate 1 (e.g., made of SiGe mixed crystal) by an atmospheric pressure CVD method, on condition that the substrate temperature is 400°C and the deposition time is 20 minutes. In this case, the SiO₂ material corresponds to the material "B".

### [1-2] Lithography (pattern formation)

A pattern made of a positive resist is in parallel crosses formed, in a period of 0.5 µm, on the SiO₂ layer shown in Fig. 2A by a stepper light exposing equipment. The process is similar to that in producing a LSI.

### [1-3] Etching of the SiO₂ layer

The SiO₂ layer is reactively etched by a fluorocarbon-hydrogen-argon based mix gas under a pressure of 5 Pa for four minutes. The SiO₂ material as the material "B" is selectively removed and thereby, the surface of the substrate (SiGe surface) is partially exposed to form etch-removed parts 2 as shown in Fig. 2B. Thereafter, the resist is removed by oxygen plasma and the surface of the thus obtained assembly is washed and treated by a solution.

### [1-4] Selective growth of SiGe mixed crystalline material

As shown in Fig. 2C, a SiGe pattern is selectively grown, of a SiH₄-GeH₄-H₂ based mix gas, in a thickness of 0.5 µm on the exposed parts of the SiO₂ pattern to the substrate by a low pressure CVD method, on condition that the substrate temperature is 550°C and the growth time is ten minutes, so that the pattern 11 is formed. In this case, the SiGe mixed crystalline material corresponds to the material "A". The pattern 11 has the arrangement of the blocks composed of the materials "A" and "B" repeated at every kind of block's composing material in both a X-direction and a Z-direction as a two-dimensional direction orthogonal to a stacking direction (Y-direction).

### [1-5] Selective formation of a Si thin layer (formation of an intervened layer).

As shown in Fig. 2D, an intervened layer 3 composed of a Si thin layer is selectively grown of SiH₄-H₂based mix gas on the upper surface of the pattern layer 11 by a low pressure CVD method, on condition that the substrate temperature is 650°C and growth time is one minute. The intervened layer 3 can be formed in a thickness of atomic order (Å order) by the above selective growth. In this embodiment, the thickness of the intervened layer 3 is about 0.03 µm. The intervened layer 3 is intervened each between the adjacent pattern layers.

The steps of [1-1] through [1-5], that is, the deposition of the SiO₂ material, the lithography (pattern formation), the etching of the SiO₂ pattern, the selective growth of the SiGe mixed crystalline material and the selective formation of the Si thin layer (formation of an intervened layer) are repeated and thereby, the pattern layer 11, the intervened layer 3, a pattern layer 12, the intervened layer 3, a pattern layer 13, the intervened layer 3, a pattern layer 14 are alternately stacked on the substrate 1, so that a desired three-dimensional periodic structure can be obtained.

According to the producing method of the three-dimensional periodic structure in this embodiment, in producing the three-dimensional periodic structure by stacking the patterns 11, 12, 13 · · · of which each has the blocks composed of the materials "A" and "B" repeatedly and regularly arranged at every kind of block's composing material in the X-direction and the Z-direction, the intervened layer (thin layer) is intervened each between the adjacent pattern layers. Thus, the pattern layer to be stacked is selectively grown on the intervened layer as a seed or an origin of the selective growth. Consequently, the shape-controlling of the pattern layer is much enhanced and thereby, a desired three-dimensional periodic structure can be obtained. Moreover, the intervened layer 3 can be formed in a very small thickness, a thickness of atomic order (Å order) by the selective growth, so that the influence for a device including this three-dimensional periodic structure can be minimized.

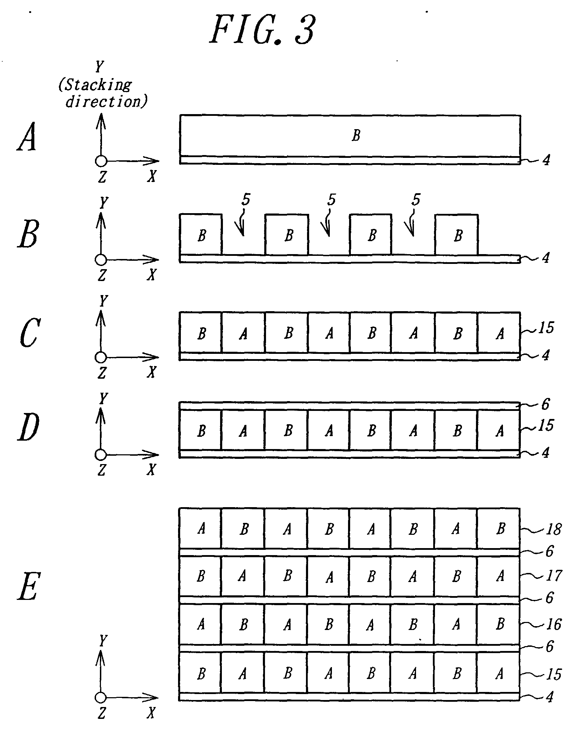

Next, a producing method of a second embodiment three-dimensional periodic structure according to the present invention will be explained with reference to Figs. 3A-3E. In this second embodiment, in producing the three-dimensional periodic structure composed of the materials "A" and "B", a SiO₂ material is used as the material "A" and a polysilicon material is used as the material "B". Moreover, the intervened layer is composed of a thin layer having a whole surface to be selectively CVD-deposited made of SiO₂ material.

### [2-1] Selective CVD deposition of a SiO₂ material (formation of a SiO₂ thin layer)

As shown in Fig. 3A, a SiO₂ thin layer is formed, of a SiH₄-O₂-N₂ based mix gas, in a thickness of 0.025 µm on a given base material (not shown) by an atmospheric pressure CVD method, on condition that the base material temperature is 400°C and the deposition time is one minute. The SiO₂ thin layer is used as a substrate 4.

### [2-2] Polysilicon deposition

As shown in Fig. 3A, a polysilicon layer is formed, of SiH₄-H₂ based mix gas, in a thickness of 0.5 µm on the substrate 4 by a low pressure CVD method, on condition that the substrate temperature is 650°C and the deposition time is 17 minutes.

### [2-3] Lithography (pattern formation)

A pattern made of a positive resist is in parallel crosses formed, in a period of 0.5 µm, on the polysilicon layer shown in Fig. 3A by a stepper light exposing equipment. The process is similar to that in producing a LSI.

### [2-4] Etching of the Polysilicon layer

The polysilicon layer having a thickness of 0.5 µm is etched by an ECR plasma etching method using a chlorine-nitrogen based mix gas and the surface of the substrate (made of SiO₂ material) is partially exposed to form etch-removed parts 5 shown in Fig. 3B. Thereafter, the resist is removed by oxygen plasma and the thus obtained assembly is washed and treated by a solution.

### [2-5] Selective wet growth of a SiO₂ material

As shown in Fig. 3C, a SiO₂ pattern is formed, of silicon hydrogen fluoride, in a thickness of 0.5 µm only on the exposed surface of the substrate 4 by a selective liquid phase growth method using selective wet growth to form a pattern layer 15. The pattern layer 15 has the arrangement of the blocks composed of the materials "A" and "B" repeated at every kind of block's composing material in both a X-direction and a Z-direction as a two dimensional direction orthogonal to a stacking direction.

### [2-6] Selective CVD deposition of a SiO₂ material (formation of an intervened layer)

As shown in Fig. 3D, a SiO₂ thin layer is formed, of a SiH₄-O₂-N₂ based mix gas, on the pattern layer 15 by an atmospheric pressure CVD method, on condition that the substrate temperature is 400°C and the deposition time is one minute. The SiO₂ thin layer is used as an intervened layer 6. The intervened layer 6 can be formed in a thickness of atomic order (Å order), and in this embodiment, its thickness is about 0.025 µm. The intervened layer 6 is intervened each between the adjacent pattern layers to be formed later.

The steps of [2-2] through [2-6], that is, the deposition of the polysilicon material, the lithography (pattern formation), the etching of the polysilicon layer, the selective wet growth of the SiO₂ material and the selective CVD deposition of the SiO₂ material are repeated and thereby, the pattern layer 15, the intervened layer 6, a pattern layer 16, the intervened layer 6, a pattern layer 17, the intervened layer 6, a pattern layer 18, · · · are alternately stacked on the substrate 4, so that a desired three-dimensional periodic structure can be obtained.

According to the producing method of the three-dimensional periodic structure in this embodiment, in producing the three-dimensional periodic structure by stacking the patterns 15, 16, 17 · · · of which each has the blocks composed of the materials "A" and "B" repeatedly and regularly arranged at every kind of block's composing material in the X-direction and the Z-direction, the intervened layer 6 is intervened each between the adjacent pattern layers. Thus, the pattern layer to be stacked is selectively grown on the intervened layer as a seed or an origin of the selective growth. Consequently, the shape-controlling of the pattern layer is much enhanced and thereby, a desired three-dimensional periodic structure can be obtained. Moreover, the intervened layer 6 can be formed in a very small thickness, a thickness of atomic order (Å order) by the selective growth, so that the influence for a device including this three-dimensional periodic structure can be minimized.

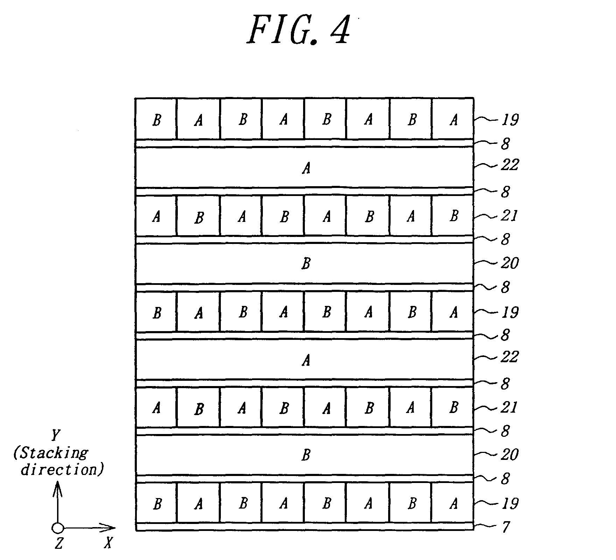

Next, a third embodiment three-dimensional periodic structure according to the present invention will be explained with reference to Fig. 4. This third embodiment three-dimensional periodic structure is produced of the same materials "A" and "B" as those in the above first and second embodiments by the same producing method as those in their embodiments.

The third embodiment three-dimensional periodic structure is different from that of the first or second embodiment in that it has the arrangement of stacked pattern layers 19-21 of which each has the bars composed of the two kinds of material "A" and "B" alternately repeated at every kind of bar's composing material in one direction (a X-direction or a Z-direction) as a two-dimensional direction orthogonal to a stacking direction. The bars in the adjacent pattern layers are orthogonal each other and are stacked in parallel crosses. Thus, on one bar composed of the material "A" or "B" in the stacking direction, the three-dimensional periodic structure has a periodic arrangement of the materials A, A, B, B, A, A, B, B · · ·. The structure has intervened layers (thin layers) each between the adjacent pattern layers as well as that in the first or second embodiment.

According to the producing method of the three-dimensional periodic structure in this embodiment, in producing the three-dimensional periodic structure by stacking the patterns 19, 20, 21, 22 · · · of which each has the bars composed of the materials "A" and "B" repeatedly and regularly arranged at every kind of bar's composing material in the X-direction or the Z-direction, the intervened layer 8 is intervened each between the adjacent pattern layers. Thus, the pattern layer to be stacked is selectively grown on the intervened layer as a seed or an origin of the selective growth. Consequently, the shape-controlling of the pattern layer is much enhanced and thereby, a desired three-dimensional periodic structure can be obtained. Moreover, the intervened layer 6 can be formed in a very small thickness, a thickness of atomic order (Å order) by the selective growth, so that the influence for a device including this three-dimensional periodic structure can be minimized.

Although in the above first through third embodiments, the three-dimensional periodic structure is produced by employing the two kinds of material "A" and "B", it may be produced by three kinds or more.

Moreover, in the above embodiments, both the materials "A" and "B" are to be selective grown, but it is sufficient that either one constituting the pattern layer is to be done.

Furthermore, as the materials "A" and "B" and the material composing the intervened layer (thin layer), Si, Ge, SiGe mixed crystal, W, Si-oxide, or a combination of these materials may be preferably used.

As the material "A" or "B", a similar material may be employed. The material "A" or "B" may be composed of air, gas, solvent. Moreover, the pattern layer may be composed of a vacuum space. In these cases, the three-dimensional periodic structure can be produced by the similar method to that of the above embodiments.

Although in the above embodiments, the intervened layer is composed of the selective grown Si thin layer or the selective CVD deposited SiO₂ thin layer, every kind of material may be used only if it can be used as a seed of selective growth.

In the first embodiment, the intervened layer is made of a different material from the materials "A" and "B", and in the second embodiment, it is made of the same material as that of either the material "A" or "B", but it may be of every kind of material only if the material can be selective grown.

The thickness of each pattern layer is micro meter-order (10⁻⁶ meter) or below.

Although in the above embodiments, the thickness of the intervened layer (thin layer) is 0.03 or 0.025 µm, it is preferably one-third or below of that of the pattern layer, more preferably atomic order (Å order; 10⁻¹⁰ order).

When the pattern layer and the intervened layer are made of Si, Ge, SiGe mixed crystal or W, they can be formed by a CVD selective growth method or a sputtering method. When they are made of Si-oxide (SiO₂, etc.), they can be formed by a selective liquid phase growth method, an atmospheric pressure CVD method or a sputtering method.

In the above embodiments, the three-dimensional periodic structure has the two-dimensional periodic arrangement of the two kinds of material "A" and "B" in its whole range, but can have the periodic arrangement only in a given position thereof by taking advantage of lithography.

Moreover, although in the above first and second embodiments, the X-direction and the Z-direction to define the two dimensional plane, orthogonal to the stacking direction (Y-direction), are orthogonal each other, they are not always orthogonal and may be crossed at an angle of 120°, which leads in the hexagonal three-dimensional periodic structure.

Although the present invention was described in detail with reference to the above examples, this invention is not limited to the above disclosure and every kind of variation and modification may be made without departing from the scope of the present invention.

As is explained above, according to the producing method, the three-dimensional periodic structure is formed through shape-controlling such as periodicity so as to have an ideal shape, so a device including such a three-dimensional periodic structure can have excellent device characteristics. Moreover, the producing method of the three-dimensional periodic structure has a high consistency with lithography technique and semiconductor integrated circuit-fabrication technique, so can be integrated on a semi-conductor substrate, and devices and circuits including such structures can be easily produced. Moreover, the intervened layer has only atomic order thickness whereby the selective growth thereof can be realized, so almost never influences the characteristics of the three-dimensional periodic structure.

## Claims

1. A three-dimensional periodic structure comprising pattern layers and thin layers, the pattern layers being stacked, the adjacent pattern layers being composed of plural different kinds of material, respectively, each pattern layer having the arrangement of the plural different kinds of material periodically repeated at every kind of material in both directions of the two-dimensional direction orthogonal to the stacking direction, each thin layer being intervened each between the adjacent pattern layers.

2. A three-dimensional periodic structure comprising pattern layers and thin layers, the pattern layers being stacked, the adjacent pattern layers being composed of plural different kinds of material, respectively, each pattern layer having the arrangement of the plural different kinds of material periodically repeated at every kind of material in one direction of the two-dimensional direction orthogonal to the stacking direction, each thin layer being intervened each between the adjacent pattern layers.

3. A three-dimensional periodic structure as defined in claim 1 or 2, wherein at least one of the plural different kinds of material is to be selectively grown and the thin layer is made of a material usable for a seed of the selective growth.

4. A three-dimensional periodic structure as defined in claim 3, wherein at least one of the plural different kinds of material and the material constituting the thin layer are Si, Ge, SiGe mixed crystal, W, Si-oxide or a combination of these materials.

5. A three-dimensional periodic structure as defined in any of claims 1-4, wherein the thickness of each pattern layer is micro meter-order or below.

6. A three-dimensional periodic structure as defined in any of claims 1-5, wherein the thickness of the thin layer is one-third or below of that of each pattern layer.

7. A method for producing a three-dimensional periodic structure comprising the steps of:
preparing a substrate,
forming a pattern layer in which plural different kinds of material are periodically repeated at every kind of material in both directions of two-dimensional direction orthogonal to its stacking direction, and
stacking the pattern layer and a thin layer alternately and repeatedly.

8. A method for producing a three-dimensional periodic structure comprising the steps of:
preparing a substrate,
forming a pattern layer in which plural different kinds of material are periodically repeated at every kind of material in one direction of two-dimensional direction orthogonal to its stacking direction, and
stacking the pattern layer and a thin layer alternately and repeatedly.

9. A method for producing a three-dimensional periodic structure as defined in claim 7 or 8, wherein at least one of the plural different kinds of material is to be selective grown and the thin layer is made of a material usable for a seed of the selective growth.

10. A method for producing a three-dimensional periodic structure as defined in claim 9, wherein at least one of the plural different kinds of material and the material constituting the thin layer are Si, Ge, SiGe mixed crystal, W, Si-oxide or a combination of these materials.

11. A method for producing a three-dimensional periodic structure as defined in claim 10, wherein the pattern layer and the thin layer are formed of Si, Ge, SiGe mixed crystal or W by a selective CVD method or a sputtering method, or of Si-oxide by a selective liquid phase-growth method, an atmospheric pressure CVD method or a sputtering method.

12. A method for producing a three-dimensional periodic structure as defined in any of claims 7-11, wherein the thickness of each pattern layer is micro meter-order or below.

13. A method for producing a three-dimensional periodic structure as defined in any of claims 7-12, wherein the thickness of the thin layer is one-third or below of that of pattern layer.
